# EUROPEAN PATENT SPECIFICATION

(11) **EP 4 167 217 B1**
(45) Date of publication and mention of the grant of the patent: **04.12.2024**
(21) Application number: 22174222.4
(22) Date of filing: 19.05.2022
(51) Int. Cl.: G09F 9/30, G06F 1/16, H04M 1/02, H05K 5/02, H05K 5/03, G09F 9/33

(54) **DOUBLE-SIDED DISPLAY**
DOPPELSEITIGE ANZEIGE
AFFICHAGE À DOUBLE FACE

(30) Priority: 14.10.2021 CN 202122479386 U
(43) Date of publication of application: 19.04.2023
(73) Proprietor: Shenzhen Infiled Electronics Co., Ltd, Tangtou, ShiyanTown, Baoan District Shenzhen Guangdong 518100 (CN)
(72) Inventor: LI, Yabin, Shenzhen, Guangdong (CN); CAI, Dengfeng, Shenzhen, Guangdong (CN); YE, Yangxiong, Shenzhen, Guangdong (CN); ZHANG, Jian, Shenzhen, Guangdong (CN)
(74) Representative: Isern Patentes y Marcas S.L.

(56) References cited:
- CN-A- 107 784 945
- CN-A- 111 223 416
- CN-U- 205 943 366

## Description

### TECHNICAL FIELD

The present disclosure relates to a technical field of display technology, and in particular to a double-sided display.

### BACKGROUND

LED display is a type of flat panel display, which consists of small LED panels and is configured to display various information such as text, images, and videos.

The LED display integrates microelectronic technology, computer technology, and information processing. It has advantages of bright colors, wide dynamic range, high brightness, long life, stable, and reliable operation. LED displays are widely used in commercial media, cultural performance markets, stadiums, information dissemination, news releases, securities trading, etc., which meet needs of different environments.

However, conventional LED displays generally can only be displayed on one side, which are unable to meet needs of users who need double-sided display.

CN 111 223 416 A discloses the preamble of claim 1.

### SUMMARY

In order to overcome deficiencies of the prior art, a purpose of the present disclosure is to provide a double-sided display with high processing efficiency. The double-sided display of the present disclosure can be used for double-sided display.

To achieve the above purpose, the present disclosure provides a double-sided display.

The double-sided display comprises a mounting frame and at least two display modules. The mounting frame comprises a first mounting surface and a second mounting surface symmetrically arranged with the first mounting surface. The at least two display modules are separately mounted on the first mounting surface and the second mounting surface.

Furthermore, the mounting frame comprises two fixing rods and a plurality of mounting rods arranged between the two fixing rods. The two fixing rods are parallelly arranged. The plurality of mounting rods are arranged at equal distances along a length direction of the fixing rods. Two ends of each of the plurality of mounting rods are respectively fixed to the two fixing rods. The two fixing rods and the plurality of mounting rods form a grid shape. The first mounting surface and the second mounting surface are formed on the plurality of mounting rods.

Furthermore, the double-sided display further comprises a reinforcing rib. The reinforcing rib is arranged between the two fixing rods and is arranged in parallel with the two fixing rods. Mounting grooves matched with the plurality of mounting rods are provided on the reinforcing rib.

Furthermore, the at least two display modules comprise a plurality of LED lamp beads.

Furthermore, fixing frames are arranged on two ends of the mounting frame; fixed holes are on the fixing frames.

Furthermore, the double-sided display further comprises a controller communicated with the at least two display modules.

Furthermore, a fixed groove configured to mount the controller is arranged in one of the fixing frames.

Compared with the prior art, in the present disclosure, the first mounting surface and the second mounting surface configured to mount the at least two display modules are formed on the mounting frame, so that the double-sided display of the present disclosure performs double-sided display, so as to meet needs of users.

### BRIEF DESCRIPTION OF DRAWINGS

FIG.1 is a schematic diagram of a double-sided display of the present disclosure.
FIG.2 is an enlarged view of portion A shown in FIG. 1.
FIG.3 is a schematic diagram of a reinforcing rib of the double-sided display of the present disclosure.

In the drawings: 1, mounting frame; 101, fixing rod; 102, mounting rod; 1021, first mounting surface; 103, reinforcing rib; 1031, mounting groove; 104, fixing frame; 2, LED lamp bead.

### DETAILED DESCRIPTION

The present disclosure will be further described below with reference to the accompanying drawings and specific embodiments. It should be noted that, on the premise of no conflict, the embodiments or technical features described below can be arbitrarily combined to form new embodiments.

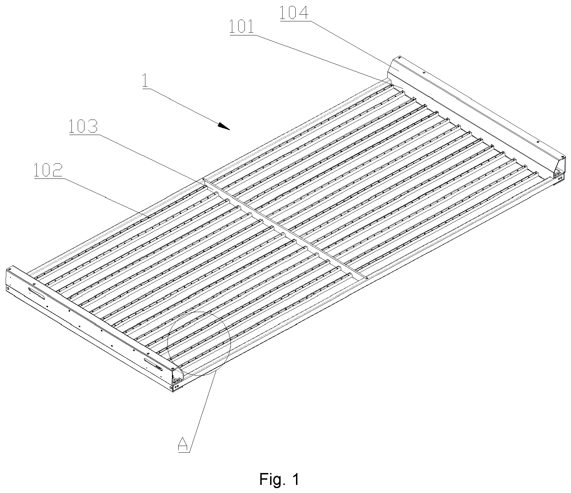

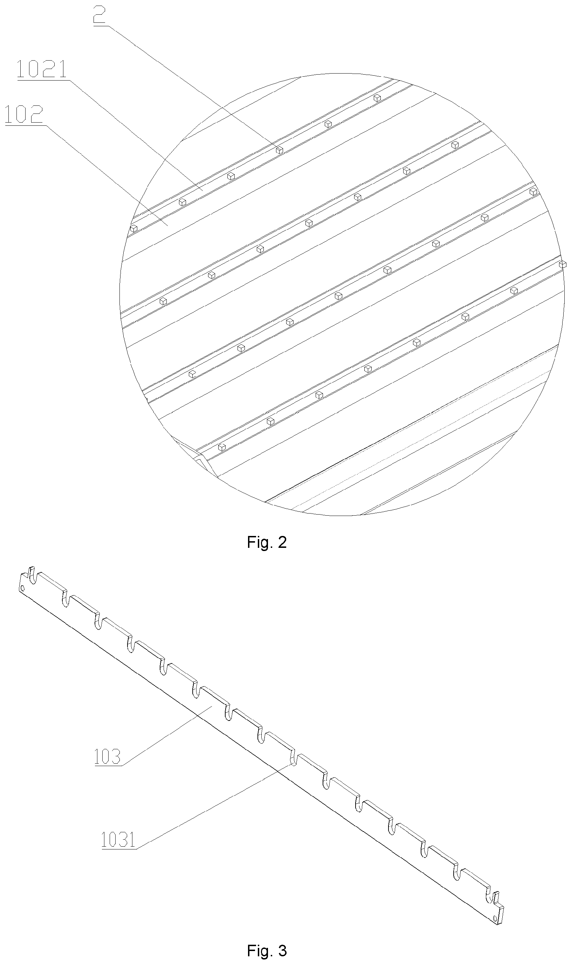

As shown in FIGS. 1-3, the double-sided display of the present disclosure comprises a mounting frame 1 and at least two display modules. The mounting frame 1 comprises a first mounting surface 1021 and a second mounting surface symmetrically arranged with the first mounting surface 1021. The at least two display modules are separately mounted on the first mounting surface 1021 and the second mounting surface.

In the present disclosure, the first mounting surface 1021 and the second mounting surface configured to mount the at least two display modules are formed on the mounting frame 1, so that the double-sided display of the present disclosure performs double-sided display, so as to meet needs of users.

Optionally, the mounting frame 1 comprises two fixing rods 101 and a plurality of mounting rods 102 arranged between the two fixing rods 101. The two fixing rods 101 are parallelly arranged. The plurality of mounting rods 102 are arranged at equal distances along a length direction of the fixing rods101. Two ends of each of the plurality of mounting rods 102 are respectively fixed to the two fixing rods 101. The two fixing rods and the plurality of mounting rods form a grid shape. The first mounting surface 1021 and the second mounting surface are formed on the plurality of mounting rods 102. A plurality of LED lamp beads. 2 are arranged at equal distances along a length direction of the first mounting surface 1021 and the second mounting surface to form the at least two display modules The at least two display modules cooperates with each other to form an image.

In addition, in order to enhance a structural strength of the double-sided display of the present disclosure, the double-sided display further comprises a reinforcing rib 103. The reinforcing rib 103 is arranged between the two fixing rods 101 and is arranged in parallel with the two fixing rods 101. Mounting grooves 1031 matched with the plurality of mounting rods 102 are provided on the reinforcing rib 103.

During installation, the mounting rods 102 are inserted into the mounting grooves 1031 and then locked, so that the plurality of mounting rods 102 are connected by the reinforcing rib 103. Then the two ends of each of the plurality of mounting rods 102 are connected with the two fixing rods 101 to complete the installation of the double-sided display.

Meanwhile, in order to facilitate the installation of the double-sided display of the present disclosure, fixing frames 104 are arranged on two ends of the mounting frame 1. Fixed holes are on the fixing frames 104. During use, a user can use bolts or other locking elements to mount the fixing frames 104 on a wall or an external fixing bracket.

Of course, the double-sided display further comprises a controller communicated with the at least two display modules. The user is able to control images displayed by the at least two display modules through the controller. An image displayed by a display module mounted on the first mounting surface 1021 may be same or different with an image displayed by the other display module mounted on the second mounting surface.

Furthermore, in order to avoid loosening of the controller, a fixed groove configured to mount the controller is arranged in one of the fixing frames.

By mounting the controller in the fixed groove and fixing the controller with bolts, the controller is effectively prevented from loosening. In the present disclosure, the controller is selected from a current conventional LED controller, which is not limited by the present disclosure, and the user can choose a suitable controller according to actual needs.

The above-mentioned embodiments are only optional embodiments of the present disclosure, and are not intended to limit the protection scope of the present disclosure. Any insubstantial changes and replacements made by those skilled in the art based on the present disclosure should fall within the protection scope of the present disclosure.

## Claims

1. A double-sided display, comprising: a mounting rack (1) and at least two display modules; wherein the mounting rack (1) comprises a first mounting surface (1021) and a second mounting surface symmetrically arranged with the first mounting surface (1021); the at least two display modules are separately mounted on the first mounting surface (1021) and the second mounting surface, wherein the double-sided display further comprises a controller communicating with the at least two display modules,
**characterized in that**,
fixing frames (104) are arranged on two ends of the mounting rack (1); fixing holes are arranged on the fixing frames (104); the fixing frames are mountable on a wall or an external fixing bracket using locking elements through the fixing holes,
wherein fixing grooves are arranged in the fixing frames (104); the controller is mounted on the fixing grooves with bolts.

2. The double-sided display according to claim 1, wherein the mounting rack (1) comprises two fixing rods (101) and a plurality of mounting rods (102) arranged between the two fixing rods (101); the two fixing rods (101) are parallelly arranged; the plurality of mounting rods (102) are arranged at equal distances along a length direction of the fixing rods (101); and two ends of each of the plurality of mounting rods (102) are respectively fixed to the two fixing rods (101); the two fixing rods and the plurality of mounting rods form a grid shape; the first mounting surface (1021) and the second mounting surface are formed on the plurality of mounting rods (102).

3. The double-sided display according to claim 2, wherein the double-sided display further comprises a reinforcing rib (103); the reinforcing rib (103) is arranged between the two fixing rods (101) and is arranged in parallel with the two fixing rods (101); mounting grooves (1031) matched with the plurality of mounting rods (102) are provided on the reinforcing rib (103).

4. The double-sided display according to claim 1, wherein the at least two display modules comprise a plurality of LED lamp beads (2).

## Patentansprüche

1. Beidseitige Anzeige, die Folgendes umfasst: ein Montagegestell (1) und mindestens zwei Anzeigemodule; wobei das Montagegestell (1) eine erste Montagefläche (1021) und eine zweite Montagefläche, die symmetrisch mit der ersten Montagefläche (1021) angeordnet ist, umfasst; die mindestens zwei Anzeigemodule separat auf der ersten Montagefläche (1021) und der zweiten Montagefläche montiert sind, wobei die beidseitige Anzeige ferner eine Steuerung umfasst, die mit den mindestens zwei Anzeigemodulen kommuniziert,
**dadurch gekennzeichnet, dass**,
an zwei Enden des Montagegestells (1) Befestigungsrahmen (104) angeordnet sind; an den Befestigungsrahmen (104) Befestigungslöcher angeordnet sind; die Befestigungsrahmen an einer Wand oder einer externen Befestigungshalterung unter Verwendung von Verriegelungselementen durch die Befestigungslöcher montierbar sind, wobei in den Befestigungsrahmen (104) Befestigungsnuten angeordnet sind; die Steuerung mit Schrauben an den Befestigungsnuten montiert ist.

2. Beidseitige Anzeige nach Anspruch 1, wobei das Montagegestell (1) zwei Befestigungsstangen (101) und eine Vielzahl von Montagestangen (102) umfasst, die zwischen den zwei Befestigungsstangen (101) angeordnet sind; die zwei Befestigungsstangen (101) parallel angeordnet sind; die Vielzahl von Montagestangen (102) in gleichen Abständen entlang einer Längenrichtung der Befestigungsstangen (101) angeordnet sind und zwei Enden von jeder der Vielzahl von Montagestangen (102) jeweils an den zwei Befestigungsstangen (101) befestigt sind; die Befestigungsstangen und die Vielzahl von Montagestangen eine Gitterform bilden; die erste Montagefläche (1021) und die zweite Montagefläche an der Vielzahl von Montagestangen (102) gebildet sind.

3. Beidseitige Anzeige nach Anspruch 2, wobei die beidseitige Anzeige ferner eine Verstärkungsrippe (103) umfasst; die Verstärkungsrippe (103) zwischen den zwei Befestigungsstangen (101) angeordnet ist und parallel zu den zwei Befestigungsstangen (101) angeordnet ist; Montagenuten (1031), die auf die Vielzahl von Montagestangen (102) abgestimmt sind, an der Verstärkungsrippe (103) bereitgestellt sind.

4. Beidseitige Anzeige nach Anspruch 1, wobei die mindestens zwei Anzeigemodule eine Vielzahl von LED-Lampenperlen (2) umfassen.

## Revendications

1. Affichage double face, comprenant : un bâti de montage (1) et au moins deux modules d'affichage ; dans lequel le bâti de montage (1) comprend une première surface de montage (1021) et une seconde surface de montage agencée symétriquement avec la première surface de montage (1021) ; les au moins deux modules d'affichage sont montés séparément sur la première surface de montage (1021) et la seconde surface de montage, dans lequel l'affichage double face comprend en outre un dispositif de commande communiquant avec les au moins deux modules d'affichage, **caractérisé en ce que**,
des cadres de fixation (104) sont agencés sur deux extrémités du bâti de montage (1) ; des trous de fixation sont agencés sur les cadres de fixation (104) ; les cadres de fixation peuvent être montés sur un mur ou un support de fixation externe à l'aide d'éléments de verrouillage à travers les trous de fixation,
dans lequel des rainures de fixation sont agencées dans les cadres de fixation (104) ; le dispositif de commande est monté sur les rainures de fixation avec des boulons.

2. Affichage double face selon la revendication 1, dans lequel le bâti de montage (1) comprend deux tiges de fixation (101) et une pluralité de tiges de montage (102) agencées entre les deux tiges de fixation (101) ; les deux tiges de fixation (101) sont agencées parallèlement ; la pluralité de tiges de montage (102) sont agencées à des distances égales le long d'une direction de longueur des tiges de fixation (101) ; et deux extrémités de chacune de la pluralité de tiges de montage (102) sont respectivement fixées aux deux tiges de fixation (101) ; les deux tiges de fixation et la pluralité de tiges de montage forment un profil de grille ; la première surface de montage (1021) et la seconde surface de montage sont formées sur la pluralité de tiges de montage (102).

3. Affichage double face selon la revendication 2, dans lequel l'affichage double face comprend en outre une nervure de renfort (103) ; la nervure de renfort (103) est agencée entre les deux tiges de fixation (101) et est agencée parallèlement aux deux tiges de fixation (101) ; des rainures de montage (1031) adaptées à la pluralité de tiges de montage (102) sont prévues sur la nervure de renfort (103).

4. Affichage double face selon la revendication 1, dans lequel les au moins deux modules d'affichage comprennent une pluralité de billes de lampe à DEL (2).
